# EUROPÄISCHE PATENTSCHRIFT

(11) **EP 1 251 358 B1**
(45) Veröffentlichungstag und Bekanntmachung des Hinweises auf die Patenterteilung: **06.05.2009**
(21) Anmeldenummer: 02006770.8
(22) Anmeldetag: 25.03.2002
(51) Int. Cl.: G01R 31/28, H05K 1/02

(54) **Vorrichtung und Verfahren zum Herstellen und Testen von Elektronik-Baugruppen**
Device for and method of manufacturing and testing electronic modules
Dispositif et procédé pour fabriquer et tester des modules électroniques

(30) Priorität: 02.04.2001 DE 10116406
(43) Veröffentlichungstag der Anmeldung: 23.10.2002
(73) Patentinhaber: Power-One AG, 8610 Uster (CH)
(72) Erfinder: Keating, David, Castletroy, Limerick (IE)
(74) Vertreter: Behrmann, Niels

(56) Entgegenhaltungen:
- WO-A-97/42515
- DE-U- 29 622 830
- DE-U- 29 700 805
- US-A- 5 031 073
- US-A- 5 544 069
- US-A- 5 798 638

## Beschreibung

Die vorliegende Erfindung betrifft eine Vorrichtung zum Herstellen und Testen einer Mehrzahl von bevorzugt identischen Elektronik-Baugruppen, insbesondere der Leistungselektronik, nach dem Oberbegriff des Patentanspruchs 1.

Derartige Vorrichtungen sind aus den DE 296 22 830 U oder der US 5,798,638 bekannt, um Elektronik-Baugruppen effizient zu bestücken. Genauer gesagt ist das Panel eine Leiterplatte, auf welcher in den jeweiligen Flächenbereichen jeweils die Leiterplattenstrukturen zum Bestücken mit Elektronikkomponenten für die Elektronik-Baugruppen gebildet sind; typischerweise enthält ein solches Panel 10 bis 30 in Matrixform angeordneter Flächenbereiche für gleiche Elektronik-Baugruppen, die dann in einem gemeinsamen Bestückungsvorgang in einem Bestückungsautomaten (üblicherweise nutzt das Panel eine wirtschaftlich sinnvolle Bestückungsfläche eines Bestückungsautomaten aus) bestückt werden können.

Nach dem Bestücken bzw. Löten erfolgt dann das Auftrennen des Panels, indem die bestückten Flächenbereiche von einem unbestückten, umgebenden Rahmenbereich des Panels (Trägerplatte), etwa durch Sägen oder Brechen, separiert werden.

Auf diese Weise kann dann in einem Arbeitsgang effizient eine größere Anzahl von (üblicherweise gleichen) Elektronik-Baugruppen hergestellt werden, und diese werden nunmehr einzeln jeweiligen Gehäusen zugeordnet und dann getestet bzw. in einem Lastbetrieb für einen vorbestimmten Zeitraum (burn-in) betrieben, um die ordnungsgemäße Funktionsfähigkeit der jeweiligen Module herzustellen.

Für diesen burn-in bzw. weitere Funktionstests existieren (oft ebenfalls automatisierte) Test- und Prüfautomaten, wobei herkömmlicherweise (in ansonsten bekannter Weise) jede Elektronik-Baugruppe als Prüfling mit Betriebsspannungssignalen sowie weiteren Test- bzw. Lastsignalen versehen wird; typischerweise geschieht dies mit Hilfe von aus dem Stand der Technik allgemein bekannten Kontaktfederstiften od. dgl. Kontaktmitteln, wobei es insbesondere im Bereich der Leistungselektronik bei entsprechend hohen Strömen, die auch schon während der burn-in- bzw. Testphasen fließen müssen, besonders günstig ist, wenn ein betreffender Prüfling auch schon über entsprechend bestückte Stecker od. dgl. Kontakteinrichtungen verfügt.

Insbesondere jedoch bei der SMD-Technologie und wenn, etwa aus Design- oder Platzgründen, keine Steckerelemente bestückt und verlötet wurden, ist das Anlegen von Betriebsspannungs- und Lastsignalen für hohe Ströme problematisch: burn-in-Vorgänge können mehrere Stunden oder gar Tage dauern, und bei Spannungswandlern od. dgl. Elektronik-Baugruppen der Leistungselektronik fließen Ströme von mehreren Ampere über einen Prüfkontakt. Dies führt dann zu entsprechend hohen Anforderungen an die Kontaktgüte bzw. die Minimierung der entsprechenden Übergangswiderstände, bis hin zur Unmöglichkeit eines echten Volllastbetriebes, da gängige externe Prüfsysteme mit aufsetzbaren Kontaktnadeln od. dgl. Kontaktelementen für die Prüflinge für derartige Stromstärken entweder a priori nicht geeignet sind, oder aber die (zwangsläufig hohen) Übergangswiderstände bei den kontaktierten Leistungen zu entsprechend starker Erwärmung der Anordnung führen.

Ein weiterer potentieller Nachteil derartiger Testverfahren, insbesondere im Gebiet der Leistungselektronik, ist, dass ein Kontaktieren mit einem Prüfautomaten für die anfallenden hohen Ströme typischerweise nur schlecht automatisierbar ist bzw. hohen Rüst- und Montageaufwand erfordert, so dass auch hier beträchtlicher (und in der Großserie kostenträchtiger) Aufwand entsteht.

Aufgabe der vorliegenden Erfindung ist es daher, eine gattungsgemäße Vorrichtung zum Herstellen von Elektronik-Baugruppen, insbesondere im Hinblick auf ihre Testeigenschaften für einen Hochleistungs- bzw. Hochstrombereich, weiterzuentwickeln, die Testgüte und die praktische Durchfuhrbarkeit von Tests unter Vollast über einen längeren Zeitraum zu verbessern (oder gar erst zu ermöglichen), und generell das Testen von Elektronik-Baugruppen der Leistungselektronik im Anschluss an ein automatisiertes Bestückungsverfahren ökonomischer, schneller und zuverlässiger zu gestalten.

Die Aufgabe wird durch die Vorrichtung mit den Merkmalen des Hauptanspruchs sowie das Verfahren nach dem unabhängigen Patentanspruch 6 gelöst; vorteilhafte Weiterbildungen der Erfindung sind in den Unteransprüchen beschrieben.

In erfindungsgemäß vorteilhafter Weise ist die Trägerplatte so ausgebildet, dass sie nicht nur das (aus dem Stand der Technik ja schon allgemein bekannte) Bestücken mit Elektronik-Bauelementen in den jeweils einer Elektronik-Baugruppe zugeordneten Flächenbereichen ermöglicht, zusätzlich weist die Trägerplatte mittels des zentralen elektrischen Anschlussbereichs, welcher bevorzugt randseitig an der Trägerplatte gelegen ist und ein Zusammenwirken mit einem externen Kontaktstecker ermöglicht, die Möglichkeit auf, im noch nicht separierten Zustand den jeweiligen Elektronik-Baugruppen gleichzeitig Betriebsspannungs- sowie Lastsignale zuzuleiten, so dass noch in diesem Zustand als unseparierter Gesamtplatte ein vollständiger Funktionstest sämtlicher Einheiten möglich ist. Dabei ist es einerseits vorgesehen, sämtliche Elektronik-Baugruppen parallel zu betreiben, andererseits besteht jedoch die Möglichkeit, für jede Elektronik-Baugruppe individualisierte Signale anzulegen, da, wie es einer bevorzugten Weiterbildung zu entnehmen ist, insbesondere die Last- und/oder Signalleitungen inviduell für jede Elektronik-Baugruppe vorgesehen, aus dem zentralen elektrischen Anschlussbereich herausgeführt und getrennt ansteuerbar sind.

Erfindungsgemäß ermöglicht wird dies dadurch, dass die Trägerplatte auch außerhalb der Flachenbereiche für die eigentlichen Elektronik-Baugruppen in den Leitungsschichten ausgebildete Leiterbahnen aufweist, wobei diese Leiterbahnen den zentralen elektrischen Anschlussbereich mit den Leiterbahnen in den jeweiligen Flächenbereichen verbinden und zu diesem Zweck auch über die Trennbereiche geführt sind. Dabei ist besonders bevorzugt im Rahmen der Erfindung für jede der Mehrzahl von Elektronik-Baugruppen im Rahmenbereich sowie in einem zugehörigen Trennbereich mindestens eine Last- und/oder Signalleitung vorgesehen, die individuell über den elektrischen Anschlussbereich extern kontaktierbar ist und über Versorgungsleitungen ohnehin eine Beaufschlagung mit der Betriebsspannung erfolgt. Durch geeignete Dimensionierung der jeweiligen Leitungsschichten bzw. Leitungen ist sichergestellt, dass auch für Vollasttests nötige hohe Ströme fließen können, und durch die Integration in die gemeinsame Trägerplatte stets eine optimale Kontaktsicherheit bzw. Signalübertragung zu den jeweiligen bestückten Flächenbereichen als Prüflingen möglich ist. Kontaktprobleme, wie sie insbesondere bei extern aufgesetzten Kontaktstiften von Prüfungsautomaten bei hohen Strömen und über mehrstündige Testzeiträume entstehen, sind damit vollständig ausgeschlossen, auch die Gefahr, dass, etwa aufgrund von Kontaktproblemen, eigentlich funktionstüchtige Baugruppen fälschlicherweise als fehlerhaft erkannt und ausgesondert werden.

Dabei ist es besonders bevorzugt, die Trennbereiche so zu gestalten, dass diese einerseits noch genügend Platz für ein Führen der Leiterbahnen zu bzw. von den Flächenbereichen bieten, andererseits jedoch ein späteres Separieren erleichtern. In ansonsten bekannter Weise dürften sich hierfür wiederum Trennverfahren durch Sägen (mit entsprechend rotierenden Sägeblättern), oder durch Ausbrechen anbieten. Um dieses Separieren zu erleichtern, weist die Trägerplatte bereits geeignete schlitzförmige Durchbrüche auf, welche schon weitgehend die Kontur des jeweiligen Flächenbereichs und damit des späteren Elektronikmoduls vorgeben.

Besonders bevorzugt ist es, die Trägerplatte und mithin die Flächenbereiche beidseitig zu bestücken; insbesondere wenn diese dann auch noch als Multilayer mit einer Mehrzahl von innenliegenden Leiterbahnschichten ausgestaltet ist, lassen sich so hochkompakte Anordnungen realisieren und bieten entsprechend viele Möglichkeiten, in der erfindungsgemäßen Weise auch über innere Layerschichten die Anordnung zu testen bzw. zu Versorgungszwecken zu kontaktieren.

Erfindungsgemäß ist es zudem vorgesehen, auf eine Bestückungsseite einen Kontaktrahmen aufzusetzen; derartige Kontaktrahmen lassen sich im Rahmen der automatisierten Bestückung und des automatisierten Lötens mit einfachem Aufwand mit montieren und bieten dann für spätere Kontaktzwecke eine gleichförmige Kontaktfläche an.

Im Ergebnis wird durch die vorliegende Erfindung der Nachteil von automatisierten Bestückungs- und Prüfverfahren speziell im Leistungselektronikbereich deutlich sichtbar überwunden, nämlich das Problem einer separaten, lösbaren Kontaktierung zu Prüfzwecken für hohe Ströme und für einen langen Zeitraum. Durch erfindungsgemäßes Nutzen des die jeweiligen Bestückungsflächen der Elektronikmodule umgebenden Rahmenbereichs für das kontaktsichere Anlegen von Versorgungs- und Signalspannungen an die einzelnen Baugruppen sowie das Abführen bzw. Zuführen mittels eines einzelnen gemeinsamen Steckers wird das Problem existierender Systeme in überraschend einfacher Weise gelöst, ohne dass dadurch die Eigenschaften für ein späteres Separieren in nachteiliger Weise beeinflusst würden.

Weitere Vorteile, Merkmale und Einzelheiten der Erfindung ergeben sich aus der nachfolgenden Beschreibung bevorzugter Ausführungsbeispiele sowie anhand der Zeichnungen; diese zeigen in:
- Fig. 1:: eine Vorrichtung zum Herstellen und Testen einer Mehrzahl von Elektronikbaugruppen gemäß einer ersten bevorzugten Ausführungsform als Draufsicht auf eine Multilayer-Printplatte als Trägerplatte im Sinne der Erfindung (best mode) und
- Fig. 2:: eine rückwärtige Ansicht der Anordnung mit Fig. 1 zum Verdeutlichen einer doppelseitigen Bestückung der Trägerplatte.

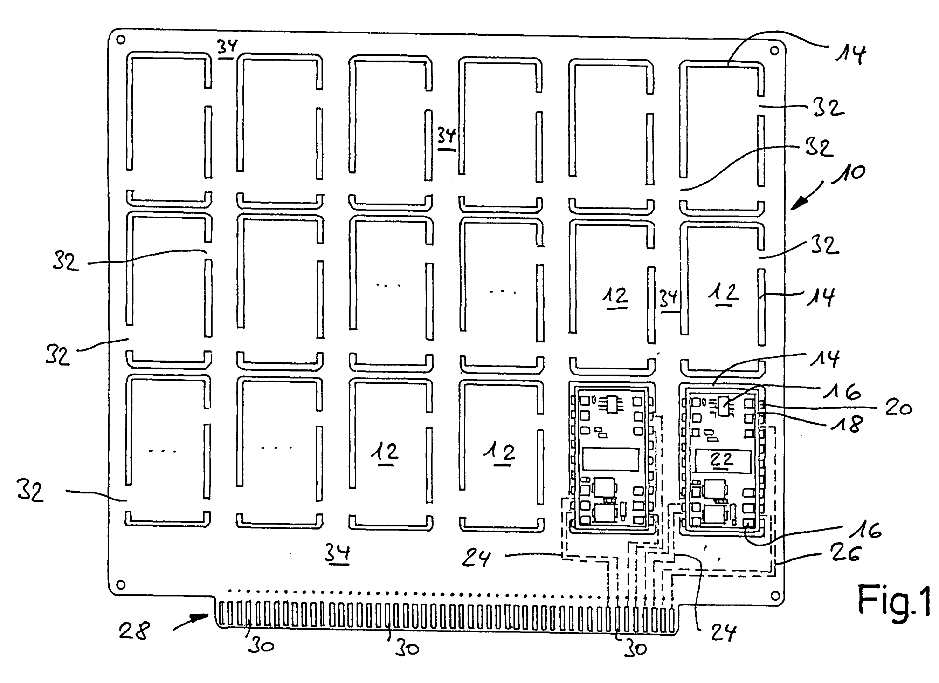

Die Anordnung gemäß Fig. 1 mit Abmessungen ca. 230 x 200 mm ist eine aus einem Multilayer-Leiterplatten-Material gebildete Vorrichtung mit einer Trägerplatte 10, innerhalb welcher -- in regelmäßigen Abständen in Matrixform angeordnet -- 18 Flächenbereiche 12, durch umgebende, längsschlitzförmige Ausschnitte 14 begrenzt, herausgebildet sind.

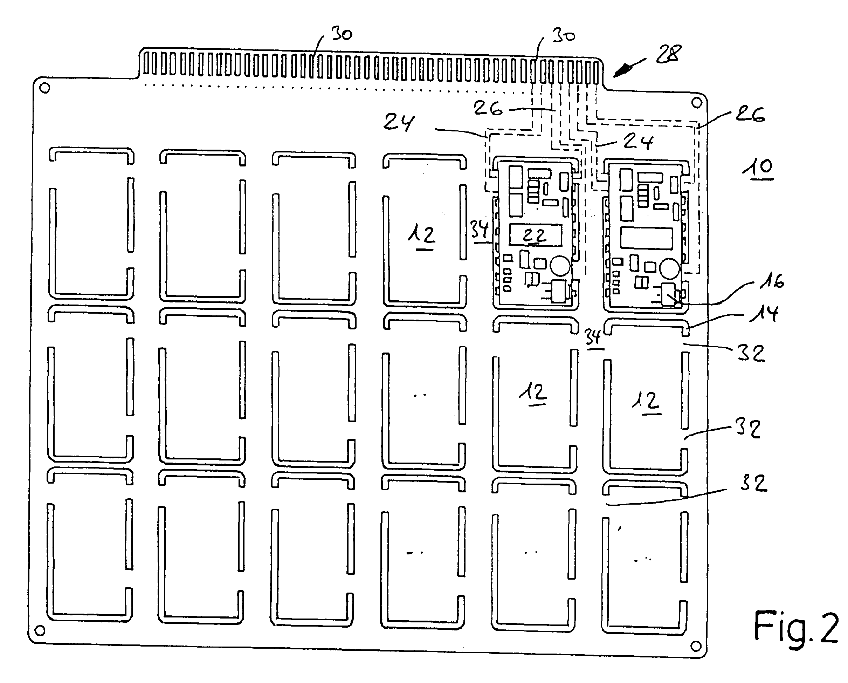

Auf jedem dieser Flächenbereiche 12 ist beidseitig eine Schaltung der Leistungselektronik (Modul) implementiert, wobei in den Darstellungen der Fig. 1 bzw. Fig. 2 lediglich zwei bestückte Flächenbereiche exemplarisch gezeigt sind. In der konkreten Realisierung ist dann die Trägerplatte 10 innerhalb der jeweiligen Flächenbereiche 12 mit Elektronikbauelementen 16 bestückt, wobei auf diese Weise dann die Trägerplatte insgesamt 18 identische Elektronikbaugruppen trägt; im dargestellten Ausführungsbeispiel handelt es sich um DC-DC-Wandler als Produkte der Leistungselektronik, die für Betriebsströme in der Größenordnung von mehreren Ampere ausgelegt sind.

Die Bestückung erfolgt in ansonsten bekannter Weise durch Bestücken der Gesamtanordnung gemäß Fig. 1 bzw. Fig. 2 (es handelt sich um eine doppelseitig bestückte Anordnung) mittels ansonsten bekannter Bestückungsautomaten bzw. SMD-fähiger Elektronik-Bauelemente, die nach dem automatisierten Bestücken dann in ebenfalls bekannter Weise automatisiert verlötet werden können.

Wie zudem die Fig. 1 verdeutlicht, ist auf einer Seite zum Zweck der späteren Kontaktierung eines vereinzelten Elektronikmoduls ein den Flächenbereich 12 umgebender Kontaktrahmen 18 vorgesehen, welcher eine Mehrzahl von in einer Ebene liegender Kontaktanschlüsse 20 anbietet, um ein Kontaktieren der betreffenden Baugruppe zu vereinfachen. Der Kontaktrahmen 18 bietet den zusätzlichen Vorteil, ebenfalls automatisch aufgesetzt bzw. verlötet werden zu können.

Wie in den Fig. schematisch angedeutet, sind neben Elektronik-Bauelementen 16 zudem Transformatorenkerne 22 bestückt, um entsprechende Funktionalitäten in den jeweiligen Baugruppen ausbilden zu können.

Im Gegensatz zu den aus dem Stand der Technik bekannten Anordnungen zum simultanen Bestücken einer Mehrzahl von identischen Baugruppen verfügt die in den Fig. 1 bzw. 2 gezeigte Anordnung zusätzlich über Spannungsversorgungsleitungen 24 bzw. Last- und Signalleitungen 26, die zum Zuführen von Betriebsspannung bzw. von Lastsignalen zu den jeweiligen bestückten Baugruppen auf der Trägerplatte 10 dienen und insoweit eine Verbindung zwischen den jeweiligen Baugruppen und einer zentralen, seitlich an der Trägerplatte 10 vorstehenden Anschlussleiste 28 herstellen.

Im gezeigten Ausführungsbeispiel erfolgt dabei eine Spannungsversorgung sowie ein Anschluss von Signalleitungen individuell für jedes bestückte Elektronikmodul im zugehörigen Flächenbereich 12 über jeweils zugeordnete Kontakte 30 der Anschlussleiste 28; alternativ ist insbesondere auch vorgesehen, die Betriebsspannungsversorgung parallel für sämtliche Baugruppen, d.h. über gemeinsame Kontakte 30, vorzusehen.

Konkret erfolgt die Führung der Versorgungs- bzw. Signalleitungen 24 bzw. 26 über mechanische Trennbereiche 32, welche innerhalb der Trägerplatte 10 Bereiche 12 mit einem umgebenden Rahmenbereich 34 der Trägerplatte 10 verbinden. Mit anderen Worten, die Trennbereiche 32 sind die jeweils verbleibenden Stege, die von den die jeweiligen Flächenbereiche 12 umgebenden Längsschlitzen 14 stehen bleiben und so für eine mechanische Verbindung zwischen Flächenbereich 12 und umgebendem Rahmenbereich 34 sorgen.

Erfindungsgemäß ist es daher möglich, Betriebs- bzw. Funktionstests der Gesamtheit von bestückten bzw. verlöteten Elektronikmodulen -- einzeln oder in ihrer Gesamtheit -vorzunehmen, ohne dass zu Testzwecken die jeweiligen Elektronikmodule zunächst (durch Auftrennen an den Trennbereichen 32) von der Trägerplatte 10 gelöst (vereinzelt) werden müssen. Vielmehr ist ein Funktions- und Testbetrieb lediglich durch Anlegen der Versorgungsspannung sowie der (selektiven) Lastsignale an die betreffenden Kontakte 30 der Anschlussleiste 28 und mithin unmittelbar an die jeweiligen Elektronikmodule möglich, wobei zu diesem Zweck idealerweise die Trägerplatte 10 lediglich mit einem Testautomaten verbunden werden muss, der zur Aufnahme bzw. zum elektrischen Verbinden ein der Anschlussleiste 28 zuzuordnendes Steckerelement aufweist und dann -- in ansonsten bekannter Weise -- Testroutinen vorgenommen werden können.

Dies ist in mehrfacher Hinsicht gegenüber dem traditionellen Testen von (ebenfalls in Mehrzahl hergestellter) Baugruppen im vereinzelten Zustand vorteilhaft: Zum einen wird die Verbindung mit einer zugehörigen Prüfeinheit drastisch vereinfacht, denn die jeweiligen einzelnen Elektronikmodule als Prüflinge müssen nicht mehr gesondert und einzeln mit dem Prüfautomaten verbunden werden, sondern dies erfolgt gemeinsam über einen Anschlussbereich mittels der Anschlussleiste 28. Zum anderen wird eine deutliche Verbesserung der Kontaktqualität für Betriebsspannungs- bzw. Lastsignale erreicht, was sich insbesondere im vorliegenden Gebiet der Leistungselektronik auswirkt. So fließen im Volllastbetrieb bei DC-DC-Wandlern als typischem Anwendungsbeispiel für die vorliegende Erfindung Ströme im Bereich von mehreren Ampere, und insbesondere ein Burn-In-Test verlangt die Aufrechterhaltung dieser Belastung über einen Zeitraum von mehreren Stunden. Eine Beaufschlagung der Prüflinge mittels bekannter Prüfstifte od.dgl. lösbarer Kontaktelemente würde beträchtliche Kontakt- bzw. Übergangswiderstände erzeugen, mit dem Ergebnis, dass nicht nur (potentiell schädliche) Wärmeentwicklung zu befürchten ist, sondern mangelnde Kontaktgüte insbesondere auch (ansonsten einwandfreie) Prüflinge als schadhaft erkennen läßt.

Auch wenn durch das Heranführen von Versorgungsspannungsbzw. Lastsignalen an die jeweiligen Flächenbereiche 12 in der Trägerplatte 10 sowie durch das zusätzliche Vorsehen der Anschlussleiste 28 zusätzlicher Aufwand beim Herstellen der Trägerplatte 10 entsteht, erscheint dieser jedoch angesichts der vorstehend beschriebenen positiven Eigenschaften eher vernachlässigbar: So steht typischerweise der (entsprechend zu bemusternde) Leiterplattenbereich in dem die Flächenbereiche 12 umgebenden Rahmenbereich 34 ohnehin zur Verfügung, so dass hier nur entsprechende Leitungen ausgebildet werden müssen (wobei hier insbesondere die beispielhafte Ausbildung der Erfindung als Multilayer weitere Vorteile hinsichtlich der flexiblen Zuführung der verschiedenen Leitungen zu den Prüflingen bietet), und auch beim Trennen bzw. Vereinzeln der jeweiligen Elektronikmodule von der Trägerplatte, typischerweise durch Sägen bzw. Brechen an den Trennbereichen 32, bringen die hier erfindungsgemäß geführten Leiterbahnen zu Versorgungs- bzw. Signalzwecken keine praktisch wirksamen Nachteile.

Im Ergebnis wird so ein integriertes Herstellungs- und Testverfahren geschaffen, welches besonders geeignet für die Serienherstellung von Produkten der Leistungselektronik ist und optimale Eigenschaften bei der Kontaktierbarkeit der jeweiligen, zu testenden Prüflinge nach dem Bestücken-- auch mit hohen Strömen und über einen längeren Zeitraum-- mit günstigen Eigenschaften für das Handling der Prüflinge beim automatisierten Einsetzen bzw. Einführen der Mehrzahl von noch nicht separierten Prüflingen in einen geeignet ausgebildeten Prüfautomaten kombiniert.

Vorliegende Erfindung ist nicht auf das beschriebene Ausführungsbeispiel beschränkt; auch wenn die Erfindung einen Schwerpunkt-Anwendungsbereich auf dem Gebiet der Leistungselektronik besitzt, so eignet sich die Erfindung prinzipiell auch für die automatisierte Fertigung und Prüfung von Elektronik-Baugruppen für andere technische Gebiete. Auch ist die Erfindung nicht auf die Verwendung von Multilayer-Printplatten und/oder doppelseitig zu bestückenden Platten beschränkt; vielmehr eignen sich für die vorliegende Erfindung beliebige Konfigurationen, auch einseitig bestückte bzw. einseitig bemusterte Leiterbahnen.

Wie vorstehend bereits beschrieben, sind zudem verschiedene Konfigurationen der Spannungsversorgungsleitungen bzw. der Last- und Signalleitungen möglich; so bietet es sich entweder an, diese jeweiligen Leitungen individuell zu jedem Prüfling (d.h. zu jedem Flächenbereich) zuzuführen, oder aber, bei individueller Zuführung der Last- und Signalleitungen, eine gemeinsame Spannungsversorgung vorzusehen, oder aber auch die Last- und Signalleitungen parallel und gemeinsam jedem Prüfling zuzuführen.

## Patentansprüche

1. Vorrichtung zum Herstellen und Testen einer Mehrzahl von bevorzugt identischen Elektronik-Baugruppen, insbesondere Elektronik-Baugruppen der Leistungselektronik, mit
- einer eine Mehrzahl von Leitungsschichten aufweisenden Trägerplatte (10) aus einem Leiterplattenmaterial,
- wobei die Mehrzahl von Elektronik-Baugruppen auf Flächenbereichen (12) der Trägerplatte durch ein bevorzugt automatisiertes Bestückungsverfahren mit Elektronik-Bauelementen (16) herstellbar und insbesondere in regelmäßigen Abständen voneinander angeordnet ist
- und die Flächenbereiche (12) an vorbestimmten, für ein Vereinzeln ausgebildeten Trennbereichen (32) der Trägerplatte an einem die Flächenbereiche umgebenden Rahmenbereich (34) der Trägerplatte gehalten sind,
- wobei die Trägerplatte im Rahmenbereich (34) einen extern kontaktierbaren, zentralen elektrischen Anschlussbereich (28) für eine Betriebsspannung oder Last der Mehrzahl von Elektronik-Baugruppen aufweist,
- jede der Mehrzahl von Elektronik-Baugruppen über im Rahmenbereich (34) sowie an einem zugehörigen Trennbereich (32) der Trägerplatte gebildete Versorgungs-, Last- und/oder Signalleitungen (24) mit der Betriebsspannung, einer Last oder einem anderen elektrischen Signal beaufschlagbar ist,
- und die vorrichtung durch Dimensionierung der Leitungsschichten so ausgebildet ist, dass die Mehrzahl von Elektronik-Baugruppen mittels der Versorgungs- sowie der Last- und/oder Signalleitungen in einem Vollastbetrieb betreib- und testbar ist,
**gekennzeichnet durch**,
einen jeder Elektronik-Baugruppe zugeordneten, auf einem betreffenden Flächenbereich bevorzugt automatisiert aufsetz- und montierbaren Kontaktrahmen (18), der für eine von der Trägerplatte separierte Elektronik-Baugruppe in einem Endmontagezustand und auch in einem Testbetrieb der unseparierten Elektronik-Baugruppe eine Kontaktfunktion übernimmt.

2. Vorrichtung nach Anspruch 1, **dadurch gekennzeichnet, dass** die Trägerplatte als Multilayer-Leiterplatte realisiert ist.

3. Vorrichtung nach Anspruch 1 oder 2, **dadurch gekennzeichnet, dass** die Trägerplatte in einem Bestückungsautomaten positionierbar ist und die Flächenbereiche mit Bauelementen automatisiert bestückbar ausgebildet sind.

4. Vorrichtung nach einem der Ansprüche 1 bis 3, **dadurch gekennzeichnet, dass** die Flächenbereiche (12), mit Ausnahme der Trennbereiche (32), von einem im Leiterplattenmaterial gebildeten, bevorzugt langgestreckten Durchbruch (14) umgeben sind und die Trennbereiche (32) als einstückige Verbindungsstege zwischen dem Rahmenbereich (34) und einem jeweiligen Flächenbereich (12) wirken.

5. Vorrichtung nach einem der Ansprüche 1 bis 4, **dadurch gekennzeichnet, dass** die Elektronik-Baugruppen durch Trennen der Flächenbereiche am Trennbereich, insbesondere durch Brechen oder Schneiden des Trennbereichs, von dem Rahmenbereich separierbar sind.

6. Verfahren zum Bestücken und Testen einer Mehrzahl von bevorzugt identischen Elektronik-Baugruppen, insbesondere Elektronik-Baugruppen der Leistungselektronik, **gekennzeichnet durch** die Schritte:
- Bestücken einer Mehrzahl von jeweils einer Elektronik-Bauguppe entsprechenden, **durch** Ausschnitte begrenzten Flächenbereichen einer Trägerplatte aus Leiterplattenmaterial mit Elektronikkomponenten,
- Betreiben einzelner oder aller der Mehrzahl von Elektronik-Baugruppen in einem Test-Vollastbetrieb **durch** Anlegen einer Versorgungsspannung sowie von bevorzugt individuellen Lastsignalen an einen gemeinsamen zentralen Anschlussbereich der Leiterplatte außerhalb der Flächenbereiche,
- Separieren der Elektronik-Baugruppen nach Beenden des Test-Vollastbetriebs **durch** Auftrennen eines Verbindungs- und Versorgungsbereichs zwischen einem betreffenden Flächenbereich und einem umgebenden Rahmenbereich der Trägerplatte
- Zuordnen einer separierten Elektronik-Baugruppe zu einem zugehörigen Gehäuse oder einer zugehörigen Montage-Baugruppe, wobei auf die Trägerplatte zum Zweck der späteren Kontaktierung einer separierten Elektronik-Baugruppe ein einen Flächenbereich umgebender Kontaktrahmen aufgesetzt wird.

7. Verfahren nach Anspruch 6, **dadurch gekennzeichnet, dass** das Bestücken der Flächenbereiche doppelseitig erfolgt.

8. Verfahren nach Anspruch 6 oder 7, **gekennzeichnet durch** das zusätzliche Kontaktieren der Flächenbereiche mit abnehmbaren Kontaktstiften einer Prüfeinrichtung.

## Claims

1. Apparatus for producing and testing a plurality of preferably identical electronic units, in particular electronic units in power electronics, comprising
- a carrier board member (10) which comprises a circuit board material and has a plurality of conduction layers,
- wherein the plurality of electronic units can be produced on surface regions (12) of the carrier board member by a preferably automated fitting process from electronic components (16) and in particular are arranged at regular distances from one another,
- and the surface regions (12) are held, at predetermined separating regions (32) of the carrier board member for the purposes of separation, to a frame region (34) of the carrier board member, which frame region extends around the surface regions,
- the carrier board member in the frame region (34) having an externally contactable central electrical connecting region (28) for an operating voltage or load for the plurality of electronic units,
- it being possible for each of the plurality of electronic units to be subjected to the operating voltage, a load or another electrical signal via supply, load and/or signal lines (24) formed in the frame region (34) and at an associated separating region (32) of the carrier board member,
- and the apparatus being constructed in such a way, in terms of the dimensions of the conduction layers, that the plurality of electronic units can be operated and tested by means of the supply as well as the load and/or signal lines in a full-load mode of operation,
**characterised by** a contact frame (18) which is associated with each electronic unit and can be fitted to and mounted on a respective surface region, preferably in an automated procedure, and which performs a contact function for an electronic unit in a final assembly state separated from the carrier board member and also in a testing mode of the unseparated electronic unit.

2. Apparatus according to claim 1, **characterised in that** the carrier board member is provided in the form of a multi-layer circuit board.

3. Apparatus according to either claim 1 or claim 2, **characterised in that** the carrier board member can be positioned in an automatic component-fitting machine and the surface regions are configured to be fitted with components by an automated procedure.

4. Apparatus according to any one of claims 1 to 3, **characterised in that** the surface regions (12), with the exception of the separating regions (32), are surrounded by an opening (14) which is formed in the circuit board material and which is preferably of an elongate configuration and the separating regions (32) act as integral connecting webs between the frame region (34) and a respective surface region (12).

5. Apparatus according to any one of claims 1 to 4, **characterised in that** the electronic units can be separated from the frame region by separating the surface regions at the separating region, in particular by breaking or cutting the separating region.

6. Method for fitting and testing a plurality of preferably identical electronic units, in particular electronic units in power electronics, **characterised by** the steps of:
- fitting electronic components to a plurality of surface regions of a carrier board member of circuit board material, which surface regions each correspond to a respective electronic unit and are delimited by cut-outs,
- operating individual electronic units or all of the plurality of electronic units in a full-load test mode by applying a supply voltage and preferably individual load signals to a common central connecting region of the circuit board outside the surface regions,
- separating the electronic units after termination of the full-load test mode by severing a connecting and supply region between a respective surface region and a surrounding frame region of the carrier board member, and
- associating a separated electronic unit with an associated housing or an associated assembly unit, a contact frame which surrounds a surface region being fitted to the carrier board member for the purpose of subsequently contacting a separate electronic unit.

7. Method according to claim 6, **characterised in that** the components are fitted to the surface regions in a double-sided manner.

8. Method according to either claim 6 or claim 7, **characterised by** additional contacting of the surface regions with removable contact pins of a testing device.

## Revendications

1. Dispositif pour fabriquer et tester une pluralité de modules électroniques de préférence identiques, en particulier de modules électroniques dans le domaine de l'électronique de puissance, doté
- d'une plaque de support (10) présentant une pluralité de couches conductrices composée d'un matériau pour circuits imprimés,
- la pluralité de modules électroniques pouvant être fabriquée sur des zones de surface (12) de la plaque de support par un procédé d'insertion de composants de préférence automatisé avec des modules électroniques (16) et étant en particulier agencée à intervalles réguliers les uns des autres,
- et les zones de surface (12) étant maintenues au niveau de zones de séparation prédéfinies, permettant leur individualisation, de la plaque de support (32), au niveau d'une zone de cadre (34) de la plaque de support entourant les zones de surface,
- la plaque de support présentant dans la zone de cadre (34) une zone de raccordement (28) électrique centrale pouvant être contactée en externe pour une tension de régime ou une charge de la pluralité de modules électroniques,
- chaque module de la pluralité de modules électroniques pouvant être alimenté, par l'intermédiaire de lignes d'alimentation, de charge et/ou d'acheminement des signaux (24) formées dans la zone de cadre (34) ainsi qu'au niveau d'une zone de séparation associée (32) de la plaque de support, avec la tension de régime, une charge ou un autre signal électronique,
- et le dispositif, grâce au dimensionnement des couches conductrices, étant réalisé de telle manière que la majorité des modules électroniques puisse être exploitée et testée en mode de pleine charge au moyen des lignes d'alimentation, de charge et/ou d'acheminement des signaux,
**caractérisé par** un cadre de contact (18) correspondant à chaque module électronique, et pouvant être placé et monté, de préférence de façon automatisée, sur une zone de surface correspondante, lequel assume une fonction de contact pour un module électronique séparé de la plaque de support lorsque le module électronique non séparé est en position d'assemblage définitif ainsi qu'en mode de test.

2. Dispositif selon la revendication 1, **caractérisé en ce que** la plaque de support est réalisée en tant que plaque conductrice multicouche.

3. Dispositif selon la revendication 1 ou 2, **caractérisé en ce que** la plaque de support peut être positionnée dans un automate d'insertion de composants et **en ce que** les zones de surface peuvent être conçues de façon à être équipées automatiquement de modules.

4. Dispositif selon l'une des revendications 1 à 3, **caractérisé en ce que** les zones de surfaces (12), à l'exception des zones de séparation (32), sont entourées d'une partie ajourée (14) de préférence allongée, formée dans le matériau pour circuits imprimés et les zones de séparation (32) jouent le rôle de passerelles formées d'une seule pièce entre la zone de cadre (34) et une zone de surface (12) correspondante.

5. Dispositif selon l'une des revendications 1 à 4, **caractérisé en ce que** les modules électronique peuvent être séparés de la zone de cadre par une séparation des zones de surfaces au niveau de la zone de séparation, en particulier en cassant ou coupant la zone de séparation.

6. Procédé d'insertion de composants et de test d'une pluralité de modules électroniques, de préférence identiques, en particulier des modules électroniques dans le domaine de l'électronique de puissance, **caractérisé par** les étapes suivantes :
- équiper de composants électroniques une pluralité de zones de surfaces d'une plaque de support constituée d'un matériau pour circuits imprimés, lesquelles correspondent chacune à un module électronique et sont limitées par des rainures,
- exploiter certains ou la totalité de la pluralité de modules électroniques en mode de test de pleine charge par l'application d'une tension d'alimentation ainsi que de signaux de charge de préférence individuels sur une zone de raccordement centrale commune de la plaque conductrice en dehors des zones de surface,
- séparer les modules électroniques une fois le test d'exploitation en pleine charge par la séparation d'une zone de liaison et d'alimentation en une zone de surface correspondante et une zone de cadre l'entourant de la plaque de support,
- attribuer un module électronique séparé à un boîtier correspondant ou un module de montage correspondant, moyennant quoi un cadre de contact entourant une zone de surface est placé sur la plaque de support en vue de l'établissement ultérieur d'un contact avec un module électronique séparé.

7. Procédé selon la revendication 6, **caractérisé en ce que** l'insertion des composants dans les zones de surface s'effectue sur les deux faces.

8. Procédé selon la revendication 6 ou 7, **caractérisé par** l'établissement d'un contact supplémentaire avec les zones de surface grâce à des fiches de contact amovibles d'un dispositif de test.
